**Europäisches Patentamt**

**European Patent Office**

**Office européen des brevets**

(19)

(11) Publication number : **0 461 875 A2**

## (12) EUROPEAN PATENT APPLICATION

(21) Application number : **91305296.5**

(22) Date of filing : **12.06.91**

(51) Int. Cl.⁵ : **H01R 9/00**

(30) Priority : **14.06.90 JP 156375/90**

(43) Date of publication of application :
**18.12.91 Bulletin 91/51**

(84) Designated Contracting States :
**DE FR GB**

(71) Applicant : **SEIKO EPSON CORPORATION**
**4-1, Nishishinjuku 2-chome**
**Shinjuku-ku Tokyo (JP)**

(72) Inventor : **Kamimura, Masaru, c/o SEIKO**
**EPSON CORPORATION**
**3-5 Owa, 3-chome**
**Suwa-shi, Nagano-ken (JP)**

(74) Representative : **Miller, Joseph et al**
**J. MILLER & CO. Lincoln House 296-302 High**
**Holborn**
**London WC1V 7JH (GB)**

(54) **Wiring connecting device.**

(57)   A wiring connecting device (1) for mounting an IC chip (2), comprises a flexible substrate (10) on which are mounted connecting wires (11,12) having connecting portions (C1,C2) for making electrical connections with the IC chip, and an aperture (h1,h2,h3) in the flexible substrate (10) completely over which the connecting portions (C1,C2) extend.

FIG. 1

(a)

EP 0 461 875 A2

The present invention relates to wiring connecting devices. In particular, though not so limited, the present invention relates to wiring connecting devices for connecting a liquid crystal display panel to a driving circuit substrate in, for example, a liquid crystal display.

In order to connect a liquid crystal display panel to a drive controlling circuit substrate in, for example, a liquid crystal display, a flexible wiring connecting member with a liquid crystal driving IC chip mounted thereon is usually employed in Large Scale Integration.

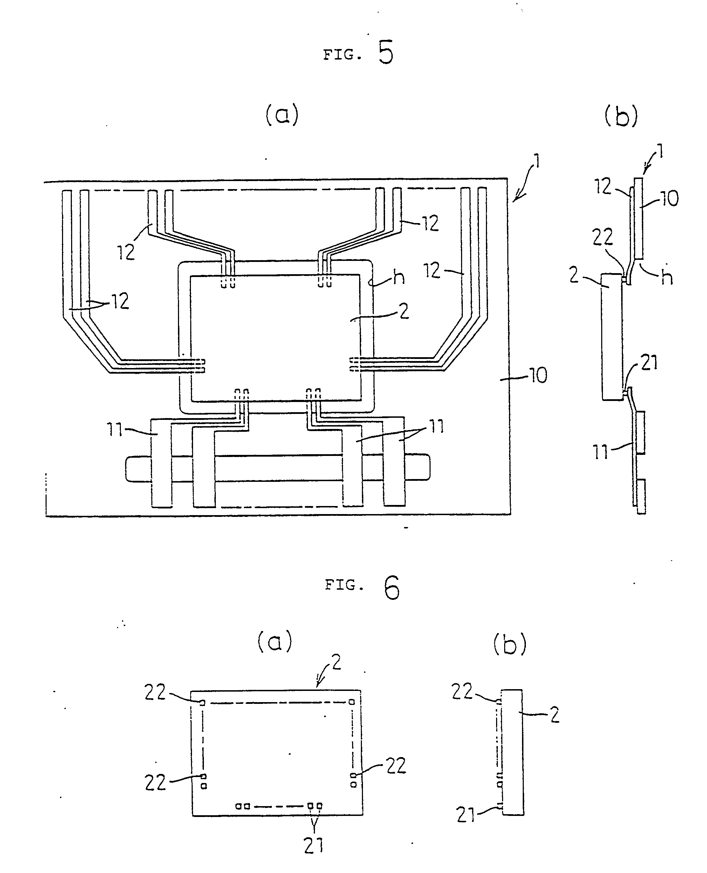

Figures 5(a) and (b) show a prior art flexible wiring connecting member, wherein reference numeral 1 denotes a flexible wiring connecting member such as an FPC (Flexible Printed Circuit) or the like for connecting a liquid crystal display panel to a driving circuit substrate, and a liquid crystal driving IC chip 2 is mounted on the wiring connecting member 1 by a TAB (Tape Automated Bonding) system or the like.

As shown in Figures 6(a) and (b), the IC chip 2 is formed in a flat rectangular shape with input terminals 21 on one side and output terminals 22 on the other three sides.

Input/output wiring 11, 12 consisting of copper foil or the like for making electrical contact with the input/output terminals 21, 22 of the IC chip 2 are formed integrally on the surface of a flexible sheet substrate 10 made of, for example, a polyimide resin.

A rectangular opening h is formed in the flexible wiring connecting member 1 at the position where the IC chip is to be mounted and the input/output terminals 21, 22 of the IC chip 2 are bonded to end portions of the wiring 11, 12 respectively which overhang the opening h. The other end of the input wiring 11 is connected to the driving circuit substrate (not shown) by soldering or other suitable means, and the output wiring 12 is connected to the electrode substrate of the liquid crystal display panel (not shown), by, for example, an anisotropic conductive bonding material.

However, since the input terminals 21 are provided on one side of the IC chip 2 and the output terminals 22 are provided on the other three sides as described above, the output wiring 12 on the flexible wiring connecting member 1 must be bent as shown in Figure 5, which incurs problems in fabrication.

Further, the wiring connections to the IC chip in a conventional connector are typically 35 μm thick, 100 to 200 μm in pitch, and consist of between 32 and 320 wires. Since the wiring is fine and narrow in pitch, damage during manufacture is likely, the yield is poor, and it is very difficult to obtain a pitch of less than 100 μm.

Recent high-resolution and colour liquid crystal displays require a greater number of finer electrodes so that a narrower pitch, particularly in the output wiring on the flexible wiring connecting member becomes necessary. It is difficult to form such wiring in a bent layout without short circuits between adjacent wires; therefore a sufficiently narrow pitch may not satisfactorily be achieved.

Furthermore, since input/output terminals are provided on all four sides of the IC chip (2), the opening in the flexible substrate must be large as shown in Figure 5. Moreover, the end portions of the input/output wires overhanging the opening must be bonded to the input/output terminals of the IC chip, therefore the wire must be sufficiently thick to give satisfactory strength to the overhanging connection.

The present invention seeks to provide a wiring connecting device having a narrow pitch yet being easy to fabricate, reliable and durable.

According to one aspect of the present invention there is provided a wiring connecting device for mounting an IC chip, said wiring connecting device comprising a flexible substrate on which are mounted a plurality of connecting wires having a plurality of connecting portions for making electrical connections with the IC chip, the wiring connecting device being characterised by an aperture in the flexible substrate completely over which the connecting portions extend.

Preferably, the wiring connecting device is characterised by a plurality of input wires and a plurality of output wires, and input connecting portions of the input wires extending completely over an elongated input aperture and output connecting portions of the output wires extending completely over an elongated output aperture.

The input and output perforations may be substantially parallel.

The wiring connecting device may include an IC chip having a plurality of terminals connected to the connecting portions of the wires.

Preferably, the IC chip is formed with two sides being substantially parallel, on one of which are provided input terminals connected to the input connecting portions, on the other of which are provided output terminals connected to the output connecting portions and on the other sides of the IC chip no terminals are provided.

Since the input terminals are provided on one side of the rectangular IC chip and the output terminals are provided on the other side, input/output wiring to the IC chip which is distributed on the flexible substrate can be simplified, thus allowing a fine pattern to be realized.

Furthermore, since the connecting portions of the input/output wiring for connecting to the IC chip are fixed to the substrate at both ends, the connecting portions are more durable.

The present invention is illustrated, merely by way of example, in the accompanying drawings, in which:-

Figures 1(a) and (b) are respectively a plan view and a sectional side view of a wiring connecting device according to the present invention;

Figures 2(a) and (b) are respectively an underside view and a side view of an IC chip;

Figures 3(a) and (b) are respectively a plan view and a sectional side view of a flexible wiring connecting member before mounting the IC chip;

Figure 4 is a cross-sectional view of the wiring portion thereof;

Figures 5(a) and (b) are respectively a plan view and a sectional side view of a prior art wiring connecting device;

Figures 6(a) and (b) are an underside view and a side view of a prior art IC chip;

Figure 7 is a cross-sectional view of a prior art flexible wiring connecting member.

Like reference numerals denote members having a similar function to those of the prior art, and their description will not be repeated hereinafter.

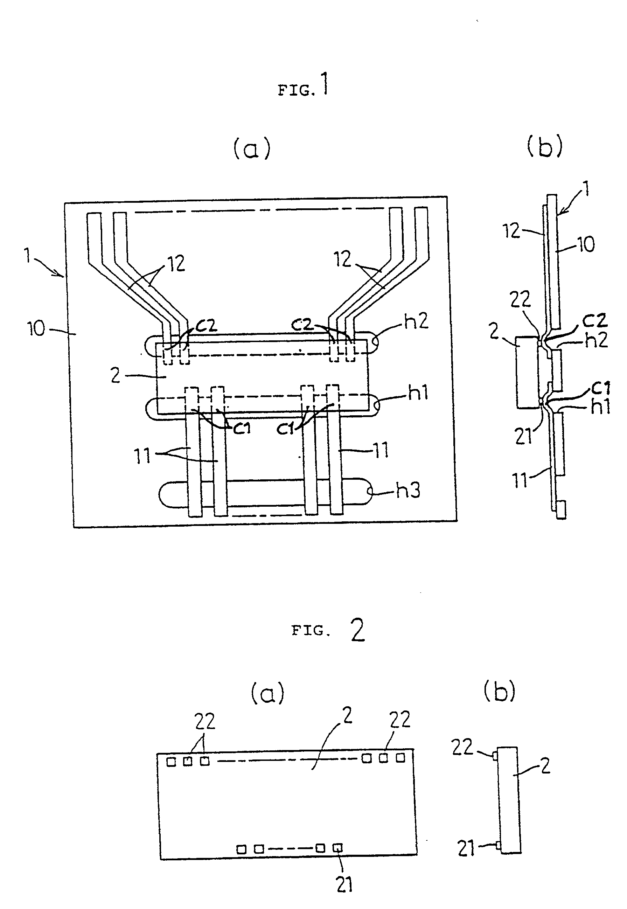

Figure 1 shows the flexible wiring connecting member 1 comprising an FPC with wiring 11, 12 formed of copper foil or the like on one side of a flexible substrate 10 made of a sheet of synthetic resin such as for example polyimide resin, and a liquid crystal driving IC chip 2 mounted on the flexible wiring connecting member 1 by the TAB system.

Input terminals 21 of the IC chip 2 are provided on one long side of the rectangular IC chip 2 as shown in Figure 2(a), and output terminals 22 are provided on the opposite side. Although Figure 2(a) is simplified there are provided in one example 20 input terminals and 160 output terminals of about 65 μm in pitch.

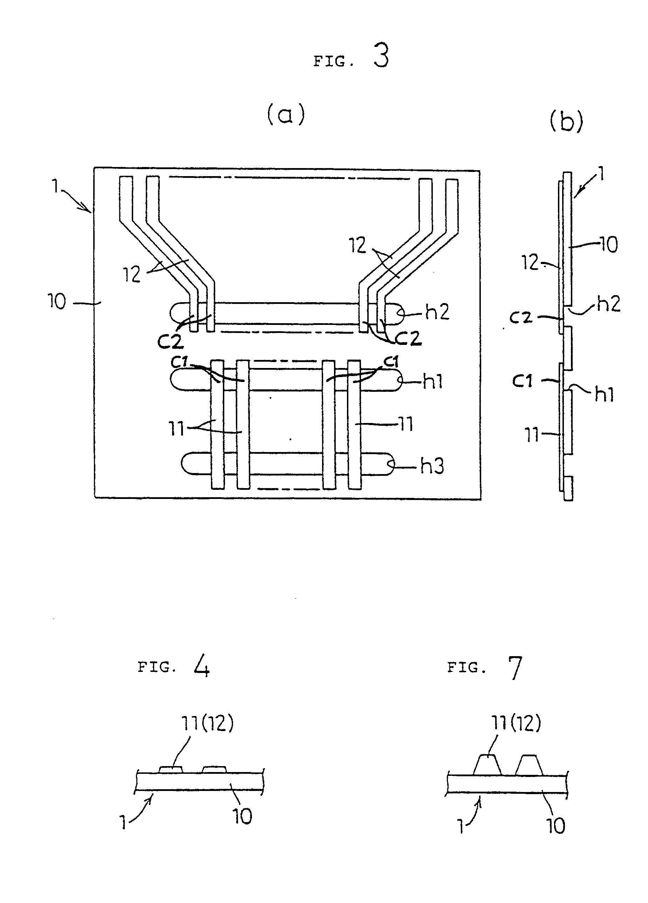

Furthermore the input wiring 11 and the output wiring 12 to the IC chip 2 are formed opposite each other on the substrate 10, as shown in Figures 1 and 3.

The chip-facing end portions of the input/output wires have the same pitch and number as the input/output terminals of the IC chip 2, and the pitch of the edge-facing end portions of the output wiring 12 is 100 μm in the example.

The chip-facing end portions of the input wiring 11 and the output wiring 12 have connecting portions not including the tips which are exposed over bonding openings h1, h2 formed by excising elongated apertures in the substrate 10.

The exposed portions are bonded, as shown in Figure 1(b), to the input/output terminals 21, 22 of the IC chip 2, and copper foil strips of the input/output wirings and the input/output terminals may be bonded to each other by pressing with a heating tool heated to about 500°C.

Then the other end of the input wiring 11 is connected to the control circuit substrate (not shown) by soldering or other suitable means as in the prior art, and the output wiring 12 is connected to the electrode substrate of a liquid crystal display panel (not shown) by an anisotropic conductive bonding material or the like. A reference character h3 denotes an opening for soldering the controlling circuit substrate to the input wiring 11.

The wiring connection may be improved further by forming the input/output wiring 11, 12 with the tips of the chip-facing ends fixed to the substrate 10 and bonding the portions of the input/output wiring 11, 12 before the tips to the input/output terminals 21, 22 of the IC chip, thereby imparting greater rigidity and strength to the wiring and allowing thinner wires to be used.

If the wiring overhangs an opening of the substrate and is electrically connected to the IC chip, as in the case of the prior art shown in Figure 5, the copper foil wires are limited to 35 μm in thickness and 100 μm in pitch; moreover, if wires 35 μm thick are used, fine patterning is made difficult by overetching as shown in Figure 7, and thus the pitch is limited to about 150 μm.

On the other hand, according to the present invention, copper foil 10 μm thick may be used to minimize the influence of overetching as shown in Figure 4, and a pattern 65 μm in pitch may be realized.

Furthermore, the pattern may be made less convoluted by distributing the input/output wirings in only two directions, allowing finer construction.

Although the embodiment has been described with reference to a liquid crystal display, the invention could also be applied to, for example, a thermal head or EL display, plasma display, or to any field in which fine connection wiring is particularly required.

## Claims

1. A wiring connecting device (1) for mounting an IC chip (2), said wiring connecting device comprising a flexible substrate (10) on which are mounted a plurality of connecting wires (11,12), having a plurality of connecting portions (C1, C2) for making electrical connections with the IC chip, the wiring connecting device being characterised by an aperture (h1,h2,h3) in the flexible substrate (10) completely over which the connecting portions (C1,C2) extend.

2. A wiring connecting device (1) as claimed in claim 1 characterised by a plurality of input wires (11) and a plurality of output wires (12) and input connecting portions (C1) of the input wires (11) extending completely over an elongated input aperture (h1) and output connecting portions (C2) of the output wires (12) extending completely over an elongated output aperture (h2).

3. A wiring connecting device (1) as claimed in claim 2 characterised in that the elongated input aperture (h1) and the elongated output aperture (h2) are substantially parallel.

4. A wiring connecting device (1) as claimed in any preceding claim in combination with an IC chip (2) having a plurality of terminals (21,22) connected to the connecting portions (C1,C2) of the wires.

5. A wiring connecting device (1) as claimed in claim 4, when dependent upon claim 3 characterised in that the IC chip (2) is formed with two sides being substantially parallel, on one of which are provided input terminals (21) connected to the input connecting portions (C1), on the other of which are provided output terminals (22) connected to the output connecting portions (C2) and on the other sides of the IC chip no terminals are provided.

6. In a wiring connecting device in liquid crystal display or the like using a flexible wiring connecting member which comprises mounting an IC chip and disposing input/output wirings to the IC chip on a flexible substrate, the improvement characterized in that: an input terminal of said IC chip is provided on one side of the chip and an output terminal is provided on the other side; the input/output wirings on said substrate connected conductively to the input/output terminals are disposed outwardly of said each side.

FIG. 1

(a)

(b)

FIG. 2

(a)

(b)

FIG. 3

(a)

(b)

FIG. 4

11(12)

1    10

FIG. 7

11(12)

1    10

FIG. 5

(a)

(b)

FIG. 6

(a)

(b)